Europäisches Patentamt

(19) European Patent Office

Office européen des brevets

(11) Numéro de publication : **0 277 855 B1**

## (12) FASCICULE DE BREVET EUROPEEN

(45) Date de publication du fascicule du brevet :
**18.12.91 Bulletin 91/51**

(51) Int. Cl.⁵ : **H03M 5/18, H04L 25/22**

(21) Numéro de dépôt : **88400070.4**

(22) Date de dépôt : **14.01.88**

(54) Convertisseur binaire-bipolaire.

(30) Priorité : **20.01.87 FR 8700568**

(43) Date de publication de la demande :
**10.08.88 Bulletin 88/32**

(45) Mention de la délivrance du brevet : ·
**18.12.91 Bulletin 91/51**

(84) Etats contractants désignés :
**CH DE GB IT LI NL**

(56) Documents cités :
**WO-A-85/02075**
**DE-A- 1 903 086**
**DE-A- 3 033 565**
**US-A- 3 370 238**
**US-A- 3 609 755**
**US-A- 4 620 310**
**PATENT ABSTRACTS OF JAPAN, vol. 6, no.
155 (E-125)[1033], 17 août 1982; & JP-A-57 76
958**

(56) Documents cités :
**PATENT ABSTRACTS OF JAPAN, vol. 3, no. 34
(E-99), 22 mars 1979, page 69; & JP-A-54 12 612**
**IBM TECHNICAL DISCLOSURE BULLETIN,
vol. 26, no. 2, juillet 1983, page 600, New York,
US; J.R. BOOK et al.: "Storage data separation"**
**PATENT ABSTRACTS OF JAPAN, vol. 6, no.
194 (E-134)[1072], 2 octobre 1982; & JP-A-57
104 351**

(73) Titulaire : **SAT Société Anonyme de
Télécommunications
40, avenue de New York
F-75116 Paris (FR)**

(72) Inventeur : **Cointot, Denis
41, rue Cantagrel
F-75631 Paris Cedex 13 (FR)**
Inventeur : **Cauderlier, André
41, rue Cantagrel
F-75631 Paris Cedex 13 (FR)**

(74) Mandataire : **Cabinet Martinet & Lapoux
BP 405
F-78055 Saint Quentin en Yvelines Cédex (FR)**

## Description

La présente invention concerne, d'une manière générale, une conversion de deux signaux binaires en un signal bipolaire ayant des impulsions, ou marques, positives et négatives correspondant alternativement à un premier état logique des deux signaux binaires.

Plus particulièrement, l'invention a trait à un convertisseur binaire-bipolaire disposée en sortie d'une partie de transmission, dite émetteur, d'un terminal reliée à une ligne de transmission distribuée dans un réseau local. Dans un tel réseau, les terminaux sont nombreux à être reliés à la ligne de transmission et doivent alors offrir une sortance élevée. Cette condition impose que le convertisseur ait une impédance de sortie élevée pendant les intervalles de temps entre les impulsions du signal bipolaire, et ait une impédance de sortie faible pendant la transmission des impulsions du signal bipolaire. Lorsque le convertisseur est à l'état d'impédance élevée, sa sortie est considérée comme "déconnectée de la ligne", et est appelée souvent à "collecteur ouvert".

Un convertisseur connu satisfaisant ces conditions d'impédance comprend, en entrée, deux portes de transfert dites à trois états, en technologie CMOS, et, en sortie, un transformateur différentiel symétrique. Les portes ont des entrées portées à une tension continue positive, des bornes de commande recevant respectivement les signaux binaires, et des sorties transmettant les impulsions respectives, positives et négatives, vers deux demi-enroulements primaires du transformateur.

Les impulsions du signal bipolaire transmis par ce convertisseur connu offrent des fronts arrière, c'est-à-dire des transitions de l'état basse impédance à l'état haute impédance, qui varient lentement. La variation lente des fronts arrière est dûe à l'énergie stockée dans le transformateur pendant les impulsions, énergie qui s'écoule lentement dans la charge de la ligne lors des fronts arrière des bits au premier état logique, généralement haut, des signaux binaires. Le temps de descente des fronts arrière d'impulsion est d'autant plus grand que l'impédance de charge est élevée, et perturbe d'autant plus la réception du signal bipolaire.

La présente invention vise principalement à fournir un convertisseur binaire-bipolaire diminuant l'effet de traînage des fronts arrière des impulsions du signal bipolaire, c'est-à-dire à éviter ou à pratiquement supprimer cet effet de traînage.

A cette fin, un convertisseur binaire-bipolaire est tel que défini dans la revendication 1.

L'invention consiste d'une manière générale à retarder le passage à l'état d'impédance de sortie élevée du convertisseur soit en retardant le passage en haute impédance de portes de transfert en entrée du convertisseur selon des réalisations énoncées dans les revendications 2 à 5, soit en déchargeant la ligne de transmission par une impulsion courte produite à la fin de chacune des impulsions bipolaires selon des réalisations énoncées dans les revendications 6 à 15.

Outre la diminution de traînage, l'invention permet également de calibrer les temps de montée et de descente des impulsions pour éviter des suroscillations engendrées par la charge capacitive de la ligne, de satisfaire à des gabarits d'impédance de la ligne en fonction de la fréquence du signal, d'utiliser en amont du convertisseur des circuits à technologie CMOS qui, par nature, offrent une faible consommation en courant et de protéger ces circuits CMOS contre toute alimentation par la ligne de transmission lorsque ces circuits ne sont pas en état normal de fonctionnement.

Diverses réalisations des moyens pour transformer les impulsions de courant en des impulsions de polarités opposées du signal bipolaire sont définies dans les revendications 16 à 22.

D'autres avantages et caractéristiques de l'invention apparaîtront plus clairement à la lecture de la description suivante de plusieurs réalisations préférées de l'invention, en référence aux dessins annexés correspondants dans lesquels :

— la Fig. 1 montre deux signaux binaires entrant et un signal bipolaire sortant d'un convertisseur binaire-bipolaire ;

— la Fig. 2 montre un convertisseur binaire-bipolaire selon la technique antérieure ;

— la Fig. 2A montre un signal bipolaire produit par le convertisseur de la Fig. 2 ;

— la Fig. 3 montre une première réalisation de convertisseur binaire-bipolaire selon l'invention ;

— la Fig. 3A montre un signal binaire entrant et un signal de commande de porte de transfert pour le convertisseur de la Fig. 3 ;

— la Fig. 4 montre une variante de circuit intégrateur retardant un signal de commande, inclus dans le convertisseur de la Fig. 3 ;

— la Fig. 4A montre un signal binaire entrant et un signal de commande de porte de transfert pour la variante de la Fig. 4 ;

— la Fig. 5 montre une autre variante de circuit de retard de signal de commande inclus dans le convertisseur de la Fig. 3 ;

— la Fig. 5A montre un signal binaire entrant et un signal de commande de porte de transfert pour la variante de la Fig. 5 ;

— la Fig. 6 montre une seconde réalisation de convertisseur binaire-bipolaire selon l'invention ;

— la Fig. 6A montre un signal bipolaire sortant et un signal de commande de grille de transistor FET pour le convertisseur de la Fig. 6 ;

— la Fig. 7 montre une variante du convertisseur de la Fig. 6 ;

— la Fig. 8 montre une troisième réalisation du convertisseur binaire-bipolaire selon l'invention ;

— la Fig. 9 montre une quatrième réalisation de convertisseur binaire-bipolaire selon l'invention ; et

— la Fig. 10 montre une réalisation pratique d'une variante du convertisseur de la Fig. 9.

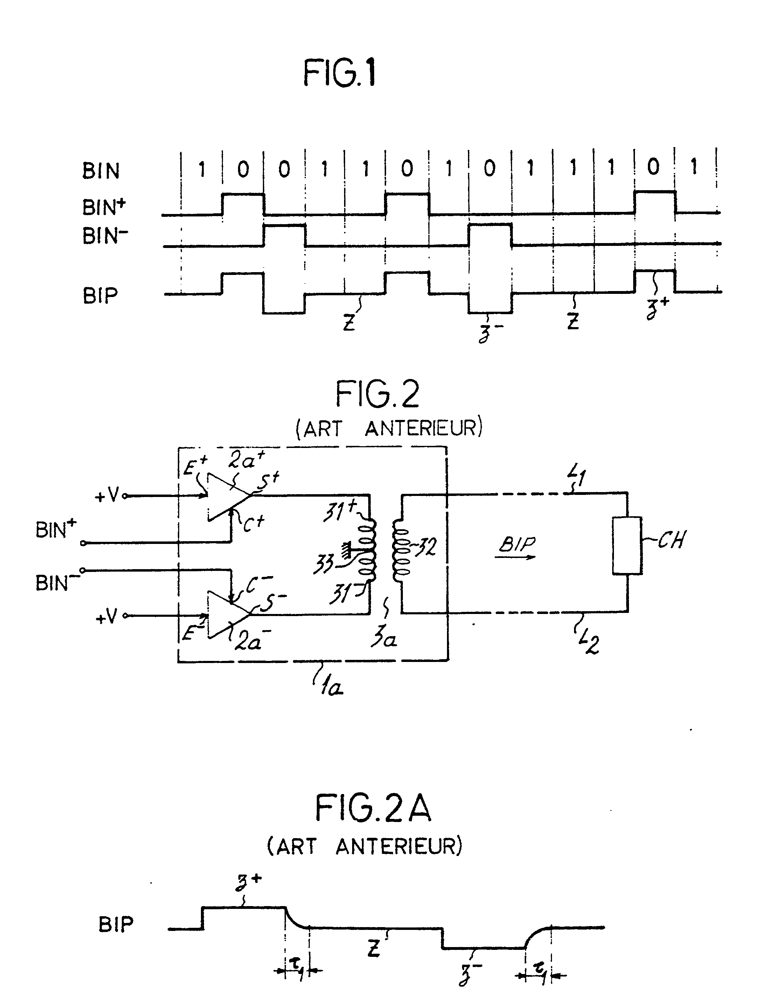

Dans la suite, référence est faite à un signal bipolaire BIP sortant d'un convertisseur binaire-bipolaire, établi à partir de deux signaux binaires composants $BIN^+$ et $BIN^-$ entrant dans le convertisseur, comme montré à la Fig. 1. Les signaux binaires $BIN^+$ et $BIN^-$, dits également signaux unipolaires, résultent de la décomposition synchrone d'un signal binaire d'information proprement dit BIN. Les bits "0" du signal BIN correspondent alternativement à des premiers états logiques "1" dans les signaux $BIN^+$ et $BIN^-$, et l'un des signaux $BIN^+$ et $BIN^-$ est à un second état logique "0" lorsque l'autre signal est au premier état "1". Les signaux binaires $BIN^+$ et $BIN^-$ sont tous deux au second état "0" lorsque le signal binaire BIN est à l'état "1".

La conversion dans un convertisseur binaire-bipolaire, tel que celui la selon la technique antérieure montré à la Fig. 2, utilise le codage pseudo-ternaire. La conversion consiste à convertir un "1" binaire du signal BIN en un digit nul Z du signal bipolaire BIP, qui traduit une absence de signal en sortie du convertisseur et par suite une impédance de sortie élevée, et à convertir un "0" binaire du signal BIN en des impulsions de courant dites marques positives et négatives $z^+$ et $z^-$, du signal BIP, qui traduisent une impédance de sortie faible du convertisseur. Les impulsions sont à polarités alternées, une impulsion positive $z^+$ correspondant à un "1" dans le signal entrant $BIN^+$, et une impulsion négative $z^-$ correspondant à un "1" dans le signal entrant $BIN^-$.

Une telle conversion binaire-bipolaire est conforme aux spécifications édictées par la recommandation I.430, "INTERFACES USAGER-RESEAU RNIS", Fascicule III.5, Section 3, pages 141 à 177, octobre 1984, du Comité Consultatif International Télégraphique et Téléphonique (C.C.I.T.T.). Cette recommandation concerne notamment un support de transmission bidirectionnel, ou interface S, entre une unité de raccordement raccordant un réseau local d'usager télématique et le réseau téléphonique, et une pluralité de terminaux d'usager, dits transcepteurs, dans un réseau numérique à intégration de service (RNIS). En particulier, de tels convertisseurs binaires-bipolaires sont inclus dans la partie de transmission, dite "émetteur", de l'unité de raccordement et dans celles des terminaux. Un terminal est à l'état haute impédance Z lorsqu'il est à l'état inactif, c'est-à-dire lorsqu'il n'est pas sous tension, ou lorsqu'il transmet un "1" logique du signal d'information binaire BIN. Le terminal est à l'état basse impédance et est à l'état actif lorsqu'il transmet un "0" logique du signal d'information binaire BIN. L'état à haute impédance Z du signal bipolaire, dit également à "collecteur ouvert", permet le raccordement des parties de transmission de nombreux terminaux au support de transmission, dite ligne de transmission distribuée, du fait qu'un tel raccordement est équivalent à une opération logique "OU câblée" ; en effet, on a $Z + Z = Z$, $Z + z = z$ et $z + z = z$. Bien que l'invention est particulièrement destinée à ce type d'application, un convertisseur binaire-bipolaire selon l'invention peut être également utilisé chaque fois qu'une conversion binaire-bipolaire est nécessaire ; par exemple, tel est le cas en sortie d'un répéteur-régénérateur numérique.

Comme montré à la Fig. 2, le convertisseur connu la comprend, en entrée, deux portes de transfert $2a^+$ et $2a^-$, et en sortie, un transformateur différentiel équilibré 3a. Les portes de transfert sont fabriquées en technologie CMOS et sont dites à trois états ("TRI-STATE"). Les portes $2a^+$ et $2a^-$ ont des entrées $E^+$ et $E^-$ portées à une tension continue positive $+V$ correspondant à l'amplitude crête des impulsions bipolaires $z^+$ et $z^-$, des entrées de commande $C^+$ et $C^-$, dites entrées de validation, recevant respectivement les signaux binaires $BIN^+$ et $BIN^-$, et des sorties $S^+$ et $S^-$ reliées respectivement à des premières bornes de deux demi-enroulements primaires $31^+$ et $31^-$ du transformateur 3a. D'autres bornes des demi-enroulements $31^+$ et $31^-$ constituent une borne centrale 33 reliée à une borne de référence à 0 volt afin de boucler des courants opposés correspondant aux impulsions $z^+$ et $z^-$. Des bornes d'un enroulement secondaire 32 du transformateur 2a sont reliées à une charge CH à travers deux fils respectifs $L_1$ et $L_2$ d'une ligne de transmission symétrique. Cette ligne peut être incluse dans un bus de transmission entre des terminaux et une unité de raccordement.

Comme il est connu, lorsqu'une porte de transfert $2a^+$, $2a^-$ a l'entrée de commande $C^+$, $C^-$ au niveau "1", correspondant en l'occurrence à l'état "1" du signal entrant $BIN^+$, $BIN^-$, la porte est à l'état conducteur et retransmet les niveaux logiques du signal entrant à l'entrée $E^+$, $E^-$, en l'occurence le niveau crête $+V$ des impulsions $z^+$, $z^-$ ; ainsi grâce à l'enroulement primaire symétrique $31^+$-$31^-$, les impulsions $z^+$ et $z^-$ sont transmises dans la ligne $L_1$, $L_2$ sous la forme d'un premier courant circulant de fil $L_1$ vers le fil $L_2$ à travers l'enroulement 32, et d'un second courant en sens contraire du précédent, respectivement. Lorsque l'entrée $C^+$, $C^-$ d'une porte $2a^+$, $2a^-$ est à l'état "0" correspondant aux états "0" du signal respectif $BIN^+$, $BIN^-$, la porte $2a^+$, $2a^-$ est bloquée et la sortie $S^+$, $S^-$ est "en l'air", c'est-à-cire offre une haute impédance, appelée troisième état, correspondant à l'état sans courant Z du signal bipolaire BIP. Cependant, une convention réciproque de la convention précédente sur les états logiques des entrées de commande peut être adoptée, en fonction des indications données par le fabricant des portes de transfert.

Comme déjà dit dans le préambule de la présente description, le convertisseur connu 1a offre un signal de sortie ayant des fronts arrière d'impulsion, c'est-à-dire des transitions de l'état $z^+$ ou $z^-$ à l'état Z dont les durées de descente sont lentes, comme montré à la Fig. 2A. En effet, dès la transition arrière de l'état "1" vers l'état "0" du signal de commande $BIN^+$, $BIN^-$, la porte de transfert respective $2a^+$, $2a^-$ est bloquée et *offre une impédance élevée ; l'énergie stockée dans* le demi-enroulement primaire respectif $31^+$, $31^-$ pendant l'état "1" du signal $BIN^+$, $BIN^-$ ne peut s'écouler que dans la charge CH, ce qui implique une constante de temps $\tau_1$, appelée traînage de front arrière d'impulsions $z^+$, $z^-$ d'autant plus grande que l'impédance de charge est élevée.

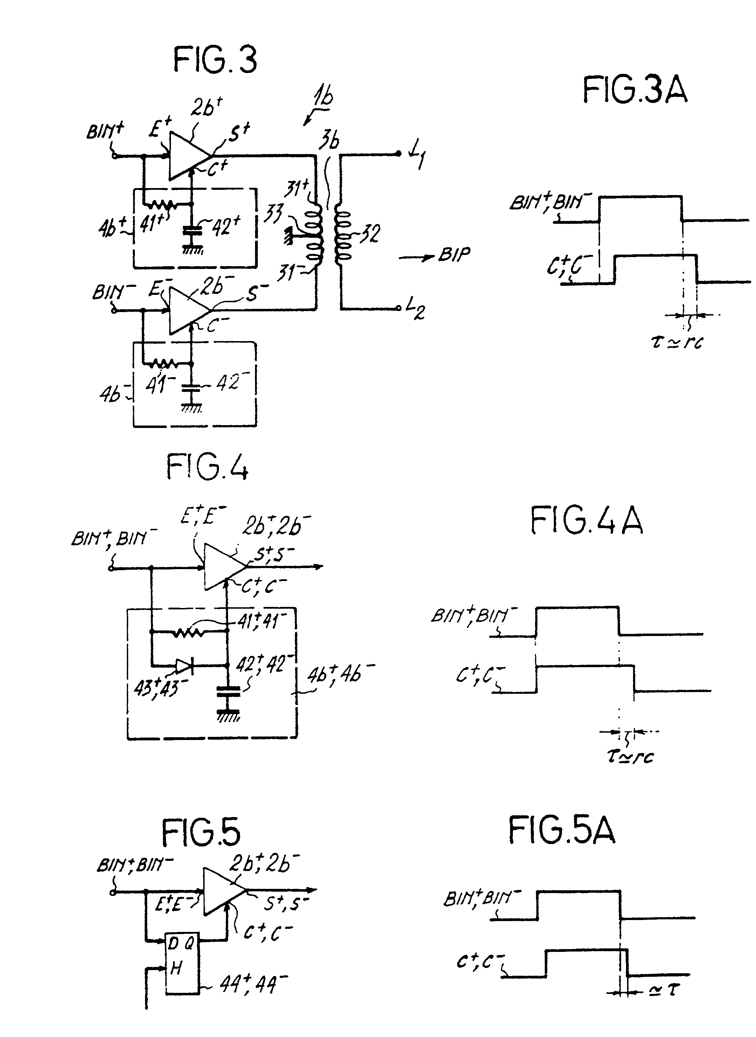

Selon une première réalisation, le traînage de front arrière est éliminé en retardant dans les signaux de commande binaires aux entrées $C^+$ et $C^-$ par rapport aux signaux appliqués aux entrées $E^+$ et $E^-$ de façon à obtenir une transition négative en état basse impédance. Dans ce cas, comme montré à la Fig. 3, un convertisseur binaire-bipolaire 1b comprend deux circuits intégrateurs $4b^+$ et $4b^-$ retardant les signaux de commande $BIN^+$ et $BIN^-$ d'au moins une durée prédéterminée $\tau$. La durée $\tau$ est au moins supérieure au temps de décharge de la ligne $L_1L_2$ à travers l'impédance active du convertisseur en entrée de la ligne, et est inférieure à la constante de traînage précédents $\tau_1$. Chaque circuit intégrateur $4b^+$, $4b^-$ comprend une résistance $41^+$, $41^-$ et un condensateur $42^+$, $42^-$ ayant des valeurs ohmique r et capacitive c telles que rc $\simeq$ $\tau$. Le convertisseur 1b comprend deux portes de transfert $2b^+$, $2b^-$ ayant des entrées $E^+$ et $E^-$ qui reçoivent les signaux respectifs $BIN^+$ et $BIN^-$ et sont reliées à des premières bornes des résistances $41^+$ et $41^-$, des entrées de commande $C^+$ et $C^-$ qui sont reliées à des secondes bornes des résistances $41^+$ et $41^-$ et à la borne de référence à 0 volt, à travers les condensateurs respectifs $42^+$ et $42^-$, et des sorties $S^+$ et $S^-$ qui sont reliées à des premières bornes de demi-enroulement primaires $31^+$ et $31^-$ d'un transformateur équilibré 3b analogue au transformateur 3a, respectivement. Comme montré à la Fig. 3A, le changement en haute impédance ou à l'état Z d'une porte $2b^+$, $2b^-$ intervient lorsque le signal à l'entrée $E^+$, $E^-$ est à l'état "0", c'est-à-dire lorsque le signal à la sortie $S^+$, $S^-$ est à l'état basse impédance, depouis au moins une durée $\tau$, durée suffisante pour éviter un traînage de front arrière.

Selon une variante de la première réalisation, chaque circuit intégrateur $4b^+$, $4b^-$ comprend un diode $43^+$, $43^-$ connectée en parallèle avec la résistance $41^+$, $41^-$ et passante de l'entrée $E^+$, $E^-$ vers l'entrée de commande $C^+$, $C^-$, comme montré à la Fig. 4. La diode $43^+$, $43^-$ supprime le retard imposé par le circuit rc, $41^+$ et $42^+$, $41^-$ et $42^-$, sur les fronts avant montants des impulsions bipolaires $z^+$ et $z^-$, comme montré à la Fig. 4A.

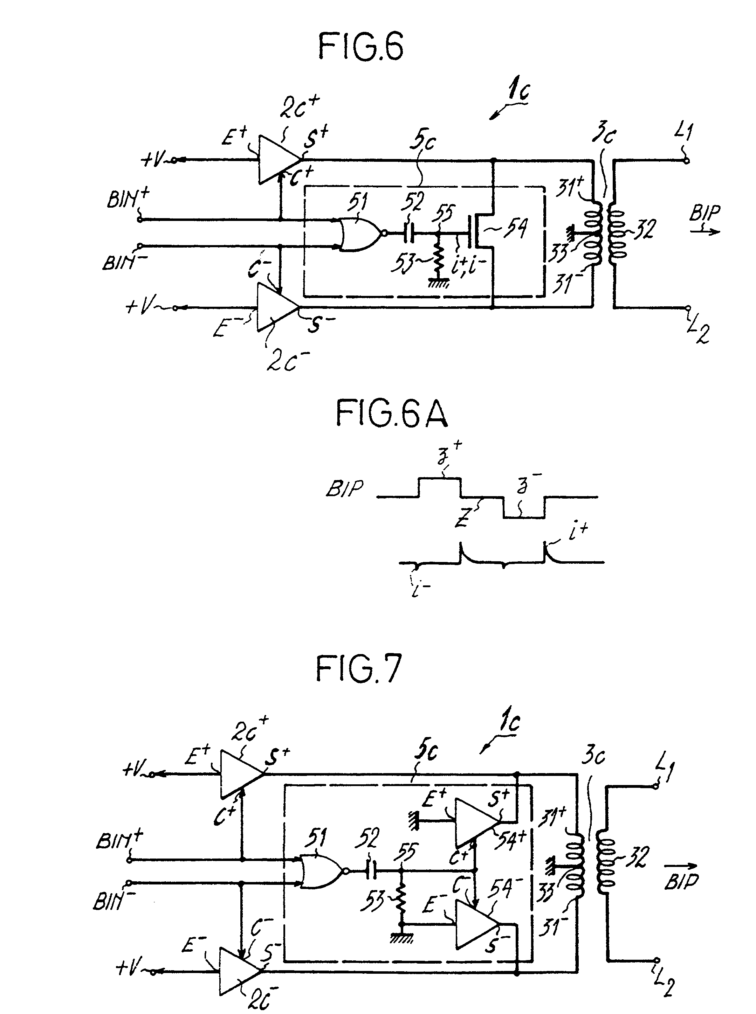

Selon une seconde variante de la première réalisation, le retard recherché de l'ordre de $\tau$ est obtenu du moyen de deux bascules bistables de type D, $44^+$ et $44^-$, remplaçant les circuits intégrateurs $4b^+$ et $4b^-$, comme montré aux Fig. 5 et 5A. Pour chaque bascule, une entrée D reçoit le signal respectif $BIN^+$, $BIN^-$, une entrée d'horloge H reçoit un signal d'horloge à haute fréquence, c'est-à-dire de fréquence nettement supérieure au débit binaire du signal binaire, et, de préférence sensiblement égale à $1/\tau$. et une sortie Q est reliée à l'entrée de commande $C^+$, $C^-$ de la porte de transfert respective $2b^+$, $2b^-$. En pratique, chaque bascule $44^+$, $44^-$ est associée à une porte à deux entrées ET ayant une entrée recevant le signal respectif $BIN^+$, $BIN^-$ et relié à l'entrée D, une autre entrée reliée à la sortie Q et une sortie reliée à l'entrée de commande $C^+$, $C^-$. Chaque combinaison numérique incluant une bascule de type D et une porte ET à deux entrées est ainsi équivalente à un circuit intégrateur $4b^+$, $4b^-$ montré à la Fig. 3.

Selon une seconde réalisation montrée à la Fig. 6, un convertisseur binaire-bipolaire 1c comprend deux portes de transfert $2c^+$ et $2c^-$ et un transformateur différentiel équilibré 3c agencés de la même manière que ceux dans le convertisseur connu 1a. De plus, le convertisseur 1c comprend un circuit 5c pour supprimer le traînage de front arrière des impulsions $z^+$ et $z^-$ dans le signal bipolaire BIP, et non pour éviter un tel traînage, comme réalisé par les circuits intégrateurs $4b^+$ et $4b^-$.

Le circuit 5c comprend une porte NON-OU 51, un circuit différentiateur à condensateur 52 et résistance 53, et un transistor à effet de champ 54. Deux entrées de la porte 51 reçoivent les signaux binaires $BIN^+$ et $BIN^-$ et sont reliées aux entrées de commande $C^+$ et $C^-$ des portes $2c^+$ et $2c^-$, respectivement. Une sortie de la porte 51 est couplée à une grille 55 du transistor 54 à travers le condensateur 52. La grille 55 est reliée à la borne de référence à travers la résistance 53. Des drain et source du transistor 54 sont reliées aux sorties $S^+$ et $S^-$ des portes $2c^+$ et $2c^-$ et aux premières bornes des demi-enroulements primaires $31^+$ et $31^-$ du transformateur 3c, respectivement.

Ainsi, la sortie de la porte NON-OU 51 délivre un signal ayant des fronts descendants et montants correspondant aux fronts avant et arrière d'impulsions "1" des signaux $BIN^+$ et $BIN^-$. Ces derniers fronts produisent des impulsions négatives $i^-$ et $i^+$ à travers le circuit différentiateur 52, 53, comme montré à la Fig. 6A, et traduisent des détections des fronts avant et arrière des signaux binaires. Dans le circuit 5c, la capacité c du condensateur 52 et la valeur ohmique r de la résistance 53 sont telles que rc$\simeq$$\tau$, où $\tau$ est le traînage de front arrière des impulsions bipolaires $z^+$ et $z^-$ à supprimer. Ainsi les impulsions $i^-$ sont sans effet sur le transistor 54 et bloquent celui-ci. Les impulsions $i^+$ saturent le transistor 54, et par suite contribuent à décharger l'énergie emmagasinée dans les inductances du transformateur 3c lorsque l'une des sorties $S^+$ et $S^-$ passe de l'état basse impédance à l'état haute impédance.

Selon une autre variante de la seconde réalisation montrée à la Fig. 7, le convertisseur 1c comprend deux autres portes de transfert 54⁺ et 54⁻ à la place du transistor 54. Les portes 54⁺ et 54⁻ ont des entrées E⁺ et E⁻ portées à 0 volt, des entrées de commande C⁺ et C⁻ reliées à la borne 55 commune au condensateur 52 et à la résistance 53, et des sorties S⁺ et S⁻ reliées aux sorties des premières portes 2c⁺ et 2c⁻ et aux premières bornes des demi-enroulements primaires 31⁺ et 31⁻.

Dans cette autre variante, les portes 54⁺ et 54⁻ sont conductrices pendant le début des impulsions i⁺, ce qui permet de diminuer notablement la largeur τ des impulsions nécessaires à la suppression du traînage de front arrière des impulsions bipolaires z⁺ et z⁻, et en outre, d'améliorer les performances du convertisseur notamment du point de vue de la consommation en courant.

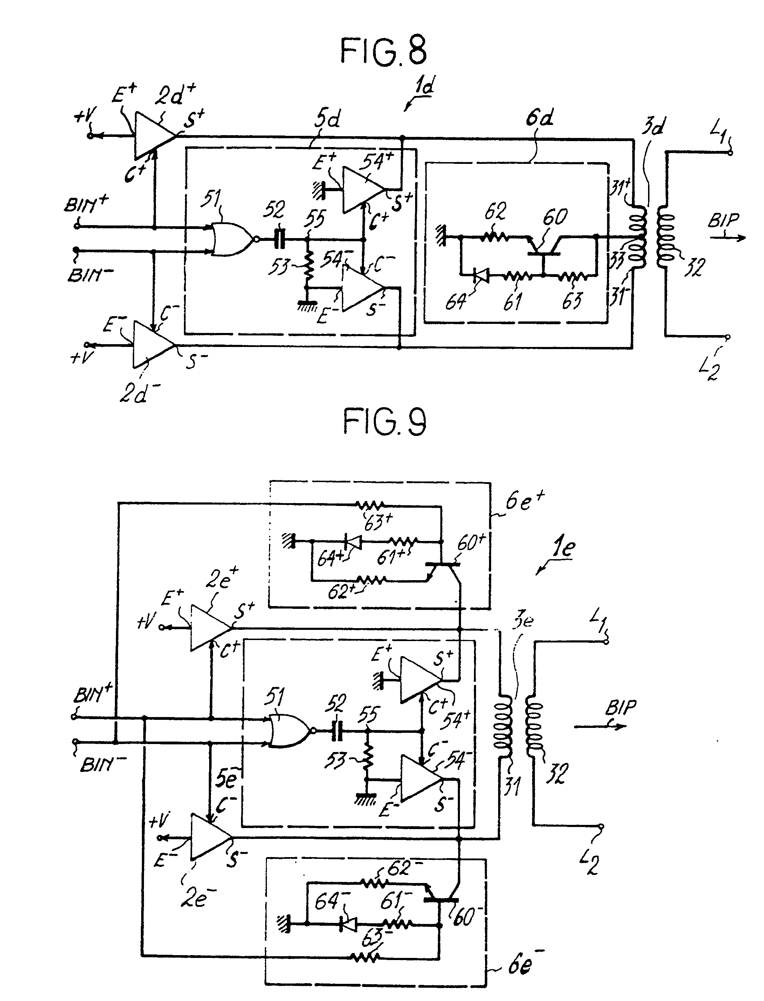

Selon une troisième réalisation illustrée à la Fig. 8, un convertisseur binaire-bipolaire 1d comporte deux portes de transfert 2d⁺ et 2d⁻, un transformateur différentiel 3d et un circuit de suppression de traînage 5d qui sont respectivement analogues aux circuits 2c⁺, 2c⁻, 3c et 5c et agencés de la même manière que dans le convertisseur 1c montré à la Fig. 7. Dans le convertisseur 1d est prévue une source de courant 6d qui couple la borne centrale 33 de l'enroulement primaire 31⁺, 31⁻ du transformateur 3d à la borne de référence à 0 volt. Une telle source de courant peut être également incluse dans les convertisseurs selon l'invention montrés aux Figs.3 à 6.

La source de courant 6d comprend un transistor bipolaire NPN, 60, ayant un collecteur relié à la borne 33, une première résistance 61 interconnectée entre une base du transistor 60 et la borne de référence, une seconde résistance 62 interconnectée à un émetteur de transistor 60 et la borne de référence, et une troisième résistance 63 reliée aux base et collecteur du transistor 60.

Les valeurs ohmiques des trois résistances 61, 62 et 63 et les caractéristiques de fonctionnement du transistor 60 sont choisies pour respecter des gabarits prédéterminés de l'impédance de sortie du convertisseur, c'est-à-dire des variations prédéterminées de ladite impédance de sortie en fonction de la fréquence ou débit du signal bipolaire BIP. En particulier, de tels gabarits sont à respecter pour l'application particulière envisagée concernant des réseaux locaux, lorsque le signal bipolaire est à l'état haute impédance Z : dans ce cas, le transistor 60 est saturé, et la source 6d est équivalente à une véritable source de courant. Lorsque le signal bipolaire est à l'état basse impédance, la source de courant 6d n'est pas saturée et est équivalente à une source de tension imposant une tension de sortie prédéterminée. La source 6d peut également fonctionner en source de courant et en source de tension pour des impédances de la charge CH respectivement inférieure et supérieure à 50 Ohms typiquement.

De préférence, la source 6d comprend une diode 64 qui est connectée en série avec la première résistance 61 et polarisée directement de la base du transistor 6d vers la borne de référence. La diode 64 est utilisée pour une compensation en température de la source. Selon une autre variante, la diode 64 est remplacée par une thermistance, telle qu'une résistance à coefficient de température négatif (CTN).

En référence à la Fig. 9, une quatrième réalisation de convertisseur binaire-bipolaire 1e comprend deux portes de transfert 2e⁺ et 2e⁻, un transformateur 3e et un circuit de suppression de traînage 5e qui sont respectivement analogues aux circuits 2c⁺, 2c⁻, 3c et 5c et sont agencés de la même manière que dans le convertisseur 1c montré à la Fig. 7, ou dans le convertisseur 1d montré à la Fig. 8. Dans le transformateur 3e, l'enroulement primaire 31 ne comporte plus de borne centrale 33, ce qui permet de limiter la capacité répartie du transformateur et remédier plus aisément aux contraintes d'impédance de sortie dans le convertisseur.

Selon la quatrième réalisation, la source de courant 6d qui était incluse dans le convertisseur 1d, est remplacée par deux sources de courant symétriques 6e⁺ et 6e⁻. Deux telles sources de courant peuvent être également incluses dans les convertisseurs selon l'invention montrés aux Figs.3 à 6.

Chaque source 6e⁺, 6e⁻ comprend un transistor NPN, 60⁺, 60⁻, une première résistance 61⁺, 61⁻, une seconde résistance 62⁺, 62⁻ et une diode 64⁺, 64⁻ ayant une cathode reliée à la borne de référence, ou une thermistance, qui sont agencés de la même manière que les composants 60, 61, 62 et 64 dans la source 6d. Des bases des transistors 60⁺ et 60⁻ sont reliées aux bornes de commande C⁻ et C⁺ des portes 2e⁻ et 2e⁺ recevant les signaux binaires BIN⁻ et BIN⁺, à travers des troisièmes résistances 63⁺ et 63⁻ respectivement. Des collecteurs des transistors 60⁺ et 60⁻ sont reliés aux sorties S⁺ des portes 2e⁺ et 54⁺ et aux sorties S⁻ des portes 2e⁻ et 54⁻, respectivement. Ainsi, la source 6e⁺, 6e⁻ est débloquée par les états "1" du signal binaire BIN⁺, BIN⁻ correspondant aux états d'impédance faible à la sortie de la porte de transfert respective 2e⁺, 2e⁻, pendant que la sortie de l'autre porte de transfert 2e⁻, 2e⁺ offre une impédance élevée.

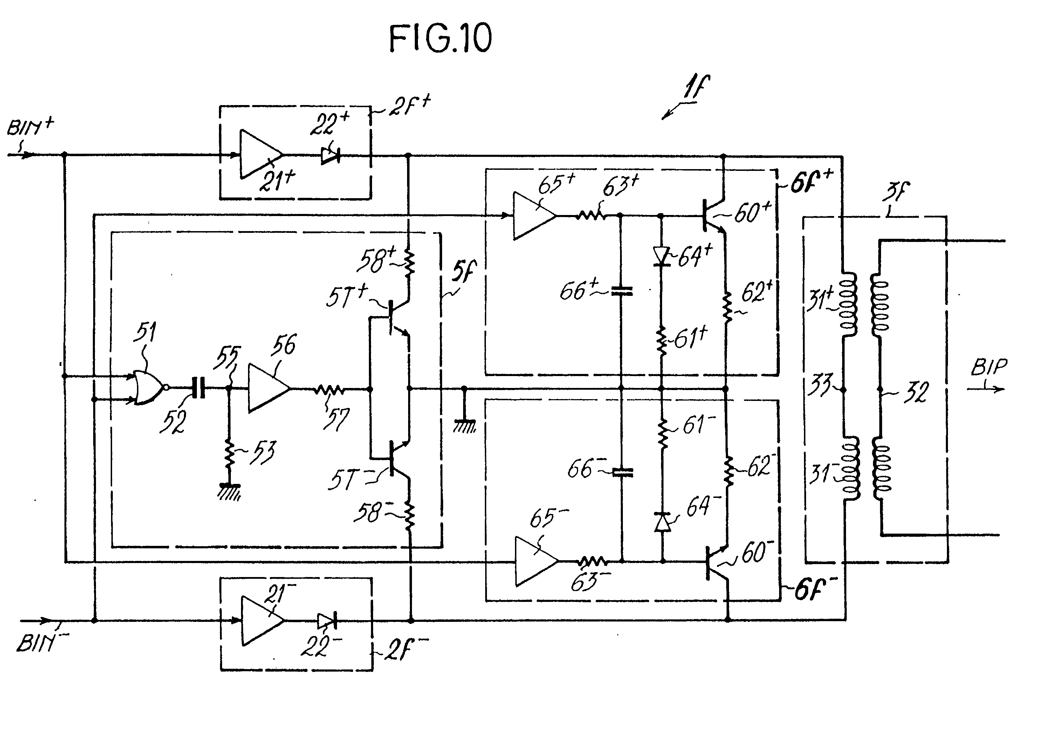

La Fig. 10 illustre une réalisation pratique d'un convertisseur binaire-bipolaire 1f correspondant au convertisseur 1e. Le convertisseur 1f comprend deux circuits d'entrée à portes 2f⁺ et 2f⁻, un transformateur de sortie 3f sans borne centrale dans l'enroulement primaire 31⁺-31⁻ reliée à la borne de référence, un circuit de suppression de traînage 5f, et deux sources de courant 6f⁺ et 6f⁻ qui sont agencés de la même manière que les circuits 2e⁺, 2e⁻, 3e, 5e, 6e⁺ et 6e⁻ dans le convertisseur 1e, par rapport aux bornes d'entrée du convertisseur recevant les signaux binaires BIN+ et BIN– et l'enroulement primaire.

Chaque circuit 2f+, 2f– comprend une porte tampon 21+, 21– et une diode 22+, 22– qui sont connectées en série entre l'entrée du convertisseur 1f recevant le signal binaire respectif BIN+, BIN– et la première borne de demi-enroulement primaire respectif 31+, 31–. La porte 21+, 21– est utilisée en tampon dit "buffer" de manière à constituer une interface logique convenable entre des circuits logiques en technologie CMOS en amont du convertisseur et des circuits logiques en technologie DTL ou TTL en aval du circuit 2f+, 2f–, tels que, notamment, un transistor 5T+, 5T– inclus dans le circuit 5f, comme on le verra dans la suite. Cette porte 21+, 21– garantit les caractéristiques de niveaux logiques et, par suite, les tensions d'alimentation dans les circuits CMOS et les circuits DTL ou TTL. La diode 22+, 22– a une anode reliée à la sortie de la porte tampon 21+, 21– et une cathode reliée à la première borne du demi-enroulement 31+, 31– de manière à être traversée par les impulsions du signal BIN+, BIN– et à protéger les circuits CMOS par tout courant de ligne en sens contraire.

Le circuit de suppression de traînage 5f comprend, en entrée, une porte NON-OU 51 ayant deux entrées reliées respectivement aux entrées des portes tampons 21+ et 21–, et un circuit différentiateur ayant des condensateur 52 et résistance 53 et relié à la sortie de la porte 51, comme dans le circuit 5e. Dans le circuit 5f sont prévus deux transistors bipolaires NPN, 5T+ et 5T–, remplaçant les portes de transfert 54+ et 54– dans le circuit 5e. Des émetteurs des transistors 5T+ et 5T– sont reliés à la borne de référence à 0 volt. Des bases des transistors 5T+ et 5T– sont reliées entre elles d'une part, et reliées à la borne commune 55 au condensateur 52 et à la résistance 53 à travers une combinaison série incluant une porte tampon 56 et une résistance de base 57, d'autre part. Le collecteur du transistor 5T+, 5T– est relié à la cathode de la diode respective 22+, 22– et à la première borne du demi-enroulement primaire respectif 31+, 31– à travers une résistance de collecteur 58+, 58–. La porte 56 joue le même rôle que les portes 21+ et 21–. Les transistors 5T+ et 5T– sont à l'état conducteur ou à l'état non-conducteur d'une manière analogue au fonctionnement des portes 54+ et 54– déjà décrit en référence à la Fig. 7.

L'avantage de l'utilisation des transistors 5T+ et 5T– réside notamment dans le pouvoir à réduire les tensions d'alimentation en ligne pour les états basse impédance, et à offrir une impédance de sortie facilement calibrable, grâce aux résistances de collecteurs 58+ et 58–, pour les fronts arrière des impulsions bipolaires z+ et z– et donc une calibration des transitions de l'état z à l'état Z correspondant au temps de descente des fronts arrière des impulsions bipolaires.

Les transistors 5T+ et 5T– et les diodes 22+ et 22– permettent également d'éviter l'activation des circuits CMOS en amont du convertisseur, et donc d'éviter une consommation intempestive de ces circuits, lorsque l'alimentation de ces circuits est absente et la ligne $L_1L_2$ convoie un signal.

Chaque source de courant 6f+, 6f– comprend un transistor bipolaire NPN 60+, trois résistances 61+, 62+ et 63+, 61–, 62– et 63–, et une diode 64+, 64– qui sont agencés de la même manière que dans la source 6e+, 6e–, et en plus, une porte tampon d'entrée 65+, 65– et un condensateur 66+, 66–. La porte tampon 65+, 65– est connectée en série avec la résistance respective 63+, 63– et a une entrée reliée à l'entrée respective du convertisseur 1f recevant l'autre signal binaire BIN–, BIN+ ; la porte 65+, 65– joue un rôle analogue aux autres portes tampon CMOS déjà citées 21+, 21– et 56. Le condensateur 66 est connecté entre la base du transistor 60+, 60– et la borne de référence, c'est-à-dire en parallèle avec la combinaison série de la résistance 61+, 61– et de la diode 64+, 64–. Les condensateurs 66+ et 66– avec les résistances 63+ et 63– facilitent un calibrage du temps de montée des fronts avant des impulsions bipolaires, de manière à réduire ce temps de montée qui est d'autant plus grand que l'impédance de sortie est grande, mais quine doit pas être trop diminué de manière à éliminer des suroscillations parasites pendant les transitions montantes.

## Revendications

1. Convertisseur binaire-bipolaire comprenant des premier et second moyens (2b+, 2b– ; 2c+, 2c– ; 2d+, 2d– ; 2e+, 2e– ; 2f+, 2f–) pour convertir un premier état logique ("1") de premier et second signaux binaires (BIN+, BIN–) en des premières et secondes impulsions bipolaires de courant (z+, z–) correspondant à des états d'impédance de sortie faible des premier et second moyens pour convertir respectivement, ledit premier état logique n'étant présent que dans l'un desdits signaux binaires à la fois, et chacun desdits moyens pour convertir étant à un état d'impédance élevée (Z) en réponse à un second état logique ("0") du signal binaire respectif, et des moyens (3b ; 3c ; 3d ; 3e ; 3f) pour transformer les premières et secondes impulsions (z+, z–) en des impulsions de polarités opposées d'un signal bipolaire (BIP) transmis dans une ligne de transmission ($L_1L_2$), caractérisé en ce qu'il comprend des moyens (4b+, 4b– ; 5c ; 5d ; 5e ; 5f) pour retarder le passage de l'état d'impédance faible à l'état d'impédance élevée (Z) des premier et second moyens pour convertir afin que l'état d'impédance de sortie faible des premier et second moyens pour convertir soit transitoirement maintenu et des fronts arrière abrupts desdites premières et secondes impulsions (z+, z–) soient produits après des transitions du premier état ("1") au second état ("0") des premier et second signaux binaires (BIN+, BIN–), respectivement.

2. Convertisseur (1b) conforme à la revendication 1, dans lequel des premier et second moyens pour convertir comprennent des première et seconde portes de transfert (2b+, 2b-), et les moyens pour retarder (4b+, 4b-) retardent les fronts arrière d'impulsion des premier et second signaux binaires (BIN+, BIN-) appliqués à des entrées (E+, E-) des première et secondes portes de tranfert (2b+, 2b-), respectivement, afin d'appliquer des signaux binaires retardés à des bornes de commande (C+, C-) des portes de transfert (2b+, 2b-).

3. Convertisseur conforme à la revendication 2, caractérisé en ce que les moyens pour retarder relatifs à l'un respectif des premier et second signaux binaires (BIN+, BIN-) comprennent un circuit intégrateur (4b+, 4b-) ayant une résistance (41+, 41-) et un condensateur (42+, 42-), ladite résistance étant connectée entre l'entrée (E+, E-) et la borne de commande (C+, C-) de la porte de transfert respective (2b+, 2b-).

4. Convertisseur conforme à la revendication 3, caractérisé en ce que le circuit intégrateur (4b+, 4b-) comprend une diode (43+, 43-) connectée en parallèle avec la résistance (41+, 41-).

5. Convertisseur conforme à la revendication 2, caractérisé en ce que les moyens pour retarder relatifs à l'un respectif des premiers et second signaux binaires (BIN+, BIN-) comprennent une bascule bistable (44+, 44-) ayant une entrée (D) reliée à l'entrée (E+, E-) de la porte de transfert respective (2b+, 2b-), une entrée d'horloge (H) recevant un signal d'horloge à haute fréquence, et une sortie (Q) reliée à la borne de commande (C+, C-) de ladite porte de transfert respective, de préférence à travers une entrée et une sortie d'une porte ET ayant une autre entrée reliée à l'entrée (E+, E-) de la porte de transfert respective.

6. Convertisseur (1f) conforme à la revendication 1, caractérisé en ce que les moyens pour retarder comprennent des moyens (58, 5f) pour appliquer des impulsions calibrées (i+) en sortie des moyens pour convertir (2f+, 2f-) en réponse à des transitions du premier état ("1") au second état ("0") des signaux binaires (BIN+, BIN-) afin de retarder des transitions de l'état d'impédance faible à l'état d'impédance élevée (Z), des premier et second moyens pour convetir (2f+, 2f-).

7. Convertisseur (1f) conforme à la revendication 1 ou 6, caractérisé en ce qu'il comprend des moyens (63+, 66+ ; 63-, 66-) en sortie des moyens pour convertir (2f+, 2f-) pour calibrer les transitions de l'état d'impédance élevée (Z) à l'état d'impédance faible des premier et second moyens pour convertir (2f+, 2f-) correspondant au temps de montée des impulsions bipolaires (z+, z-).

8. Convertisseur (1c) conforme à la revendication 1, dans lequel les premier et second moyens pour convertir comprennent des première et seconde portes de transfert (2c+, 2c-) ayant des entrées (E+, E-)

portées à une tension prédéterminée (+V) et des bornes de commande (C+, C-) recevant respectivement les premier et second signaux binaires (BIN+, BIN-), caractérisé en ce que les moyens pour retarder (5c) comprennent des moyens (51, 52, 53) pour détecter des transitions arrière du premier état logique ("1") vers le second état logique ("0") des premier et second signaux binaires (BIN+, BIN-), et des moyens (54) reliés à des sorties (S+, S-) des portes de transfert (2c+, 2c-) pour supprimer un traînage de fronts arrière dans les premières et secondes impulsions (z+, z-) en réponse aux transitions détectées (i+).

9. Convertisseur conforme à la revendication 8, caractérisé en ce que les moyens pour détecter comprennent une porte NON-OU (51) recevant les premier et second signaux binaires (BIN+, BIN-), et un circuit différentiateur (52, 53) relié à une sortie de la porte NON-OU.

10. Convertisseur conforme à la revendication 8 ou 9, caractérisé en ce que les moyens pour supprimer un traînage comprennent un transistor (54) ayant une électrode de commande reliée à une sortie (55) des moyens pour détecter (51, 52, 53), et deux autres électrodes reliées respectivement à des sorties (S+, S-) des portes de transfert (2c+, 2c-) transmettant les premières et secondes impulsions.

11. Convertisseur conforme à la revendication 8 ou 9, caractérisé en ce que les moyens pour supprimer un traînage comprennent des troisième et quatrième portes de transfert (54+, 54-) ayant des entrées (E+, E-) reliées à une borne de potentiel de référence (0 volt), des entrées de commande (C+, C-) reliées à une sortie (55) des moyens pour détecter (51, 52, 53), et des sorties (S+, S-), reliées respectivement à des sorties (S+, S-) des première et seconde portes de transfert (2c+, 2c-).

12. Convertisseur (1b) conforme à l'une quelconque des revendications 1, 6 et 7 caractérisé en ce qu'il comprend des moyens (5T+, 5T-, 22+, 22-) en sortie des moyens pour convertir, pour protéger des moyens reliés en entrée des moyens pour convertir contre toute alimentation provenant de la ligne de transmission ($L_1L_2$).

13. Convertisseur (1f) conforme à la revendication 1, caractérisé en ce que les premier et second moyens pour convertir (2f+, 2f-) comprennent chacun une porte tampon (21+, 21-) de préférence connectée en série avec une diode (22+, 22-), une entrée de la porte tampon recevant le signal binaire respectif (BIN+, BIN-) et une cathode de la diode délivrant les impulsions de courant respectives (z+, z-) ; et en ce que les moyens pour retarder (5f) comprennent des moyens (51, 52, 53) pour détecter des transitions arrière du premier état logique ("1") vers le second état logique ("0") des premier et second signaux binaires (BIN+, BIN-), et des moyens (5T+, 5T-, 56, 57) reliés aux cathodes desdites diodes (22+, 22-) pour supprimer un traînage de fronts arrière dans les premières et secondes impulsions (z⁺, z⁻) en réponse aux transitions détectées (i⁺).

14. Convertisseur conforme à la revendication 13, caractérisé en ce que les moyens pour détecter comprennent une porte NON-OU (51) recevant les premier et second signaux binaires (BIN⁺, BIN⁺), et un circuit différentiateur (52, 53) relié à une sortie de la porte NON-OU.

15. Convertisseur conforme à la revendication 13 ou 14, caractérisé en ce que les moyens pour supprimer un traînage comprennent deux transistors (5T⁺, 5T⁻) ayant des électrodes de commande reliées à une sortie (55) des moyens pour détecter (51, 52, 53) à travers une porte tampon (56) connectée en série avec une résistance (57), des secondes électrodes reliées à une borne de potentiel de référence (0 volt), et des troisièmes électrodes reliées aux cathodes desdites diodes (22⁺, 22⁻) à travers des résistances (58⁺, 58⁻) respectivement.

16. Convertisseur conforme à l'une quelconque des revendication 1 à 15, caractérisé en ce que les moyens pour transformer (3b ; 3c) comprennent un transformateur comportant deux demi-enroulements primaires (31⁺, 31⁻) ayant une borne commune (33) reliée à une borne de potentiel de référence (0 volt), et ayant deux autres bornes reliées à des sorties (C⁺, C⁻) des premier et second moyens pour convertir (2b⁺, 2b⁻ ; 2c⁺, 2c⁻) et transmettant les premières et secondes impulsions de courant (z⁺, z⁻) respectivement.

17. Convertisseur conforme à l'une quelconque des revendications 1 à 15, caractérisé en ce que les moyens pour transformer comprennent un transformateur (3d) comportant deux demi-enroulements primaires (31⁺, 31⁻) ayant des bornes respectivement reliées à des sorties (S⁺, S⁻) des premier et second moyens pour convertir (2d⁺, 2d⁻), et une source de courant (6d) interconnectée à une borne (33) commune aux demi-enroulements (31⁺, 31⁻) et à une borne de potentiel de référence (0 volt).

18. Convertisseur conforme à l'une quelconque des revendications 1 à 15, caractérisé en ce que les moyens pour transformer comprennent un transformateur (3e ; 3f) incluant un enroulement primaire (31) ayant des bornes respectivement reliées à des sorties (S⁺, S⁻) des premier et second moyens pour convertir (2e⁺, 2e⁻ ; 2f⁺, 2f⁻), et des première et seconde sources de courant (6e⁺, 6e⁻ ; 6f⁺, 6f⁻) ayant des bornes de commande (63⁺, 63⁻ ; 65⁺, 65⁻) recevant respectivement les second et premier signaux binaires (BIN⁻, BIN⁺) et des bornes de sortie (collecteurs de 60⁺, 60⁻) reliées respectivement aux sorties (S⁺, S⁻) des premier et second moyens pour convertir (2e⁺, 2e⁻ ; 2f⁺, 2f⁻).

19. Convertisseur conforme à la revendication 18, caractérisé en ce que chacune des sources de courant (6f⁺, 6f⁻) comprend à l'entrée de commande, une porte tampon (65⁺, 65⁻).

20. Convertisseur conforme à l'une quelconque des revendications 17 à 19, caractérisé en ce qu'une source de courant (6d ; 6e⁺, 6e⁻ ; 6f⁺, 6f⁻) comprend au moins un transistor (60 ; 60⁺, 60⁻), et une combinaison série incluant une résistance (61 ; 61⁺, 61⁻) et une diode (64 ; 64⁺, 64⁻) reliée entre une électrode de commande du transistor et une borne de potentiel de référence (0 volts).

21. Convertisseur conforme à la revendication 20, caractérisés en ce que la diode (64 ; 64⁺, 64⁻) est remplacée par une thermistance.

22. Convertisseur conforme à la revendication 20 ou 21, caractérisé en ce que la source de courant (6f⁺, 6f⁻) comprend un condensateur (66⁺, 66⁻) connecté en parallèle avec ladite combinaison série (61⁺, 64⁺ ; 61⁻, 64⁻).

## Patentansprüche

1. Binärer-bipolarer Umsetzer mit ersten und zweiten Einrichtungen (2b⁺, 2b⁻ ; 2c⁺, 2c⁻ ; 2d⁺, 2d⁻ ; 2e⁺, 2e⁻ ; 2f⁺, 2f⁻) zur Umsetzung eines ersten logischen Zustandes ("1") erster und zweiter binärer Signale (BIN⁺, BIN⁻) in erste und zweite bipolare Stromimpulse (z⁺, z⁻) entsprechend der Impedanzzustände jeweils des niedrigen Ausgangs der ersten und zweiten Umsetzeinrichtungen, wobei der erste logische Zustand gleichzeitig nur in einem der binären Signale auftritt und die Umsetzeinrichtungen jeweils in einem hohen Impedanzzustand (Z) als Folge eines zweiten logischen Zustands ("0") des binären Signals sind, und mit Einrichtungen (3b ; 3c ; 3d ; 3e ; 3f) zur Umsetzung der ersten und zweiten Impulse (z⁺, z⁻) in Impulse eines bipolaren Signals (BIP) entgegengesetzter Polarität, das in einer Übertragungsstrecke (L₁L₂) übermittelt wird, dadurch gekennzeichnet, daß er Einrichtungen (4b⁺, 4b⁻ ; 5c ; 5d ; 5e ; 5f) zur Verzögerung des Übergangs des niedrigen Impedanzzustandes der ersten und zweiten Umsetzeinrichtungen zum hohen Impedanzzustand (Z) aufweist, damit der Impedanzzustand des niedrigen Ausgangs der ersten und zweiten Umsetzeinrichtungen vorübergehend gehalten wird und steil abfallende hintere Flanken in den ersten und zweiten Impulsen (z⁺, z⁻) jeweils nach den Übergängen des ersten Zustands ("1") des ersten und zweiten binären Signals (BIN⁺, BIN⁻) in den zweiten Zustand ("0") erzeugt werden.

2. Umsetzer (1b) nach Anspruch 1, bei dem die ersten und zweiten Umsetzeinrichtungen erste und zweite Übertragungsgatter (2b⁺, 2b⁻) und Verzögerungseinrichtungen (4b⁺, 4b⁻) aufweisen, die die hinteren Flanken der Impulse der auf die Eingänge (E⁺, E⁻) der ersten und zweiten Übertragungsgatter (2b⁺, 2b⁻) gegebenen ersten und zweiten binären Signale (BIN⁺, BIN⁻) jeweils verzögern, um die verzögerten binären Signale auf die Steuereingänge (C⁺, C⁻) der Übertragungsgatter (2b⁺, 2b⁻) zu geben.

3. Umsetzer nach Anspruch 2, dadurch gekennzeichnet, daß die Verzögerungseinrichtungen in bezug auf jeweils eines der ersten und zweiten binären Signale (BIN⁺, BIN⁻) einen Integrierer (4b⁺, 4b⁻) mit einem Widerstand (41⁺, 41⁻) und einen Kondensator (42⁺, 42⁻) aufweisen, wobei der Widerstand zwischen den Eingängen (E⁺, E⁻) und dem Steuereingang (C⁺, C⁻) des entsprechenden Übertragungsgatters (2b⁺, 2b⁻) angeordnet ist.

4. Umsetzer nach Anspruch 3, dadurch gekennzeichnet, daß der Integrierer (4b⁺, 4b⁻) eine Diode (43⁺, 43⁻) aufweist, die parallel zum Widerstand (41⁺, 41⁻) geschaltet ist.

5. Umsetzer nach Anspruch 2, dadurch gekennzeichnet, daß die Verzögerungseinrichtungen in bezug auf jeweils eines der ersten und zweiten binären Signale (BIN⁺, BIN⁻) eine bistabile Kippstufe (44⁺, 44⁻) mit einem Eingang (D), der mit dem Eingang (E⁺, E⁻) des entsprechenden Übertragungsgatters (2b⁺, 2b⁻) verbunden ist, mit einem Zeiteingang (H), an dem ein hochfrequentes Zeitsignal anliegt, und mit einem Ausgang (Q) aufweisen, der mit dem Steuereingang (C⁺, C⁻) des entsprechenden Übertragungsgatters vorzugsweise über einen Eingang und einen Ausgang eines Gatters ET, das einen anderen mit dem Eingang (E⁺, E⁻) des entsprechenden Übertragungsgatters verbundenen Eingang aufweist, verbunden ist.

6. Umsetzer (1f) nach Anspruch 1, dadurch gekennzeichnet, daß die Verzögerungseinrichtungen Einrichtungen (58, 5f) zum Erzeugen von kalibrierten Impulsen (i⁺) am Ausgang der Umsetzeinrichtungen (2f⁺, 2f⁻) als Folge der Übergänge des ersten Zustandes ("1") der binären Signale (BIN⁺, BIN⁻) in den zweiten Zustand ("0") aufweisen, um die Übergänge des niedrigen Impedanzzustandes der ersten und zweiten Umsetzeinrichtungen (2f⁺, 2f⁻) in den hohen Impedanzzustand (Z) zu verzögern.

7. Umsetzer (1f) nach Anspruch 1 oder 6, dadurch gekennzeichnet, daß er Einrichtungen (63⁺, 66⁺; 63⁻, 66⁻) am Ausgang der Umsetzeinrichtungen (2f⁺, 2f⁻) zur Kalibrierung der Übergänge des hohen Impedanzzustandes (Z) der ersten und zweiten Umsetzeinrichtungen (2f⁺, 2f⁻) in den niedrigen Impedanzzustand entsprechend der Anstiegszeit der bipolaren Impulse (z⁺, z⁻) aufweist.

8. Umsetzer (1c) nach Anspruch 1, bei dem die ersten und zweiten Umsetzeinrichtungen erste und zweite Übertragungsgatter (2c⁺, 2c⁻) mit Eingängen (E⁺, E⁻), die mit einer vorgegebenen Spannung (+V) beaufschlagt sind, und mit Steuereingängen (C⁺, C⁻), die jeweils die ersten und zweiten binären Signale (BIN⁺, BIN⁻) aufnehmen, aufweisen, dadurch gekennzeichnet, daß die Verzögerungseinrichtungen (5c) Einrichtungen (51, 52, 53) zur Entdeckung der hinteren Übergänge des ersten logischen Zustandes ("1") der ersten und zweiten binären Signale (BIN⁺, BIN⁻) in den zweiten logischen Zustand ("0"), und mit den Ausgängen (S⁺, S⁻) der Übertragungsgatter (2c⁺, 2c⁻) verbundene Einrichtungen (54) zur Unterdrückung einer Dehnung (traînage) der hinteren Flanken der ersten und zweiten Impulse (z⁺, z⁻) infolge der entdeckten Übergänge (i⁺) aufweisen.

9. Umsetzer nach Anspruch 8, dadurch gekennzeichnet, daß die Entdeckungseinrichtungen ein NOR-Gatter (51), das die ersten und zweiten binären Signale (BIN⁺, BIN⁻) aufnimmt, und einen mit dem Ausgang des NOR-Gatters verbundenen Differenzierer (52, 53) aufweisen.

10. Umsetzer nach Anspruch 8 oder 9, dadurch gekennzeichnet, daß die Einrichtungen zur Unterdrückung einer Dehnung (traînage) einen Transistor (54) mit einer Steuerelektrode, die mit einem Ausgang (55) der Entdeckungseinrichtungen (51, 52, 53) verbunden ist, und mit zwei anderen Elektroden, die jeweils mit den Ausgängen (S⁺, S⁻) der Übertragungsgatter (2c⁺, 2c⁻) verbunden sind, zur Übertragung der ersten und zweiten Impulse aufweisen.

11. Umsetzer nach Anspruch 8 oder 9, dadurch gekennzeichnet, daß die Einrichtungen zur Unterdrückung einer Dehnung (traînage) dritte und vierte Übertragungsgatter (54⁺, 54⁻) mit Eingängen (E⁺, E⁻), die mit einer Referenzspannungsklemme (0 Volt) verbunden sind, mit Steuereingängen (C⁺, C⁻), die mit einem Ausgang (55) der Entdeckungseinrichtungen (51, 52, 53) verbunden sind, und mit Ausgängen (S⁺, S⁻), die jeweils mit den Ausgängen (S⁺, S⁻) der ersten und zweiten Übertragungsgatter (2c⁺, 2c⁻) verbunden sind, aufweisen.

12. Umsetzer (1b) nach einem der Ansprüche 1, 6 und 7, dadurch gekennzeichnet, daß er am Ausgang der Umsetzeinrichtungen Einrichtungen (5T⁺, 5T⁻, 22⁺, 22⁻) zum Schutz der Einrichtungen, die mit dem Eingang der Umsetzeinrichtungen verbunden sind, gegen jede Einspeisung aus der Übertragungsstrecke (L₁L₂) aufweist.

13. Umsetzer (1f) nach Anspruch 1, dadurch gekennzeichnet, daß die ersten und zweiten Umsetzeinrichtungen (2f⁺, 2f⁻) jede ein Pufferglied (21⁺, 21⁻), das vorzugsweise in Serie mit einer Diode (22⁺, 22⁻) geschaltet ist, aufweisen, wobei ein Eingang des Puffergliedes das entsprechende binäre Signal (BIN⁺, BIN⁻) aufnimmt und eine Kathode der Diode die entsprechenden Stromimpulse (z⁺, z⁻) abgibt, und dadurch, daß die Verzögerungseinrichtungen (5f) Einrichtungen (51, 52, 53) zur Entdeckung der hinteren Übergänge des ersten logischen Zustandes ("1") der ersten und zweiten binären Signale (BIN⁺, BIN⁻) in den zweiten logischen Zustand ("0") und mit den Kathoden der Dioden (22⁺, 22⁻) verbundene Einrichtungen (5T⁺, 5T⁻, 56, 57) zur Unterdrückung einer Dehnung (traînage) der hinteren Flanken in den ersten und zweiten Impulsen (z⁺, z⁻) als Folge der entdeckten Übergänge (i⁺) aufweisen.

14. Umsetzer nach Anspruch 13, dadurch gekennzeichnet, daß die Entdeckungseinrichtungen ein NOR-Gatter (51), das die ersten und zweiten binären Signale (BIN⁺, BIN⁻) aufnimmt, und einen Differenzierer (52, 53), der mit dem Ausgang des NOR-Gatters verbunden ist, aufweisen.

15. Umsetzer nach Anspruch 13 oder 14, dadurch gekennzeichnet, daß die Einrichtungen zur Unterdrückung einer Dehnung (traînage) zwei Transistoren (5T⁺, 5T⁻) mit Steuerelektroden, die mit einem Ausgang (55) der Entdeckungseinrichtungen (51, 52, 53) über ein Pufferglied (56), das in Serie mit einem Widerstand (57) geschaltet ist, verbunden sind, mit zweiten Elektroden, die mit einer Referenzspannungsquelle (0 Volt) verbunden sind, und mit dritten Elektroden, die mit den Kathoden der Dioden (22⁺, 22⁻) über Widerstände (58⁺, 58⁻) verbunden sind, aufweisen.

16. Umsetzer nach einem der Ansprüche 1 bis 15, dadurch gekennzeichnet, daß die Transformationseinrichtungen (3b ; 3c) einen aus zwei primären Halbwicklungen (31⁺, 31⁻) bestehenden Transformator mit einem gemeinsamen Anschluß (33), der mit einer Referenzspannungsklemme (0 Volt) verbunden ist, und mit zwei anderen Anschlüssen, die mit Ausgängen (C⁺, C⁻) der ersten und zweiten Entdeckungseinrichtungen (2b⁺, 2b⁻ ; 2c⁺, 2c⁻) verbunden sind, aufweisen, der die ersten und zweiten Stromimpulse (z⁺, z⁻) überträgt.

17. Umsetzer nach einem der Ansprüche 1 bis 15, dadurch gekennzeichnet, daß die Transformationseinrichtungen einen aus zwei primären Halbwicklungen (31⁺, 31⁻) bestehenden Transformator (3d) mit Anschlüssen, die jeweils mit Ausgängen (S⁺, S⁻) der ersten und zweiten Umsetzeinrichtungen (2d⁺, 2d⁻) verbunden sind, und mit einer Stromquelle (6d), die zwischen einen Anschluß (33), der den Halbwicklungen (31⁺, 31⁻) gemeinsam ist, und einer Referenzspannungsklemme (0 Volt) geschaltet ist, aufweisen.

18. Umsetzer nach einem der Ansprüche 1 bis 15, dadurch gekennzeichnet, daß die Transformationseinrichtungen einen Transformator (3e ; 3f) mit einer Primärwicklung (31), die jeweils mit Ausgängen (S⁺, S⁻) der ersten und zweiten Umsetzeinrichtungen (2e⁺, 2e⁻ ; 2f⁺, 2f⁻) verbundene Anschlüsse aufweist, und erste und zweite Stromquellen (6e⁺, 6e⁻ ; 6f⁺, 6f⁻) mit Steuereingängen (63⁺, 63⁻ ; 65⁺, 65⁻), die jeweils die ersten und zweiten binären Signale (BIN⁻, BIN⁺) aufnehmen, und mit einem Ausgang (Kollektor von 60⁺, 60⁻), der jeweils mit den Ausgängen (S⁺, S⁻) der ersten und zweiten Umsetzeinrichtungen (2e⁺, 2e⁻ ; 2f⁺, 2f⁻) verbunden ist, aufweisen.

19. Umsetzer nach Anspruch 18, dadurch gekennzeichnet, daß jede der Stromquellen (6f⁺, 6f⁻) am Steuereingang ein Pufferglied (65⁺, 65⁻) aufweist.

20. Umsetzer nach einem der Ansprüche 17 bis 19, dadurch gekennzeichnet, daß eine Stromquelle (6d ; 6e⁺, 6e⁻ ; 6f⁺, 6f⁻) wenigstens einen Transistor (60 ; 60⁺, 60⁻) und eine serielle Schaltung aus einem Widerstand (61 ; 61⁺, 61⁻) und einer Diode (64 ; 64⁺, 64⁻), die zwischen einer Steuerelektrode des Transistors und einer Referenzspannungsquelle (0 Volt) angeordnet ist, aufweist.

21. Umsetzer nach Anspruch 20, dadurch gekennzeichnet, daß die Diode (64 ; 64⁺, 64⁻) durch einen thermischen Widerstand (thermistance) ersetzt ist.

22. Umsetzer nach Anspruch 20 oder 21, dadurch gekennzeichnet, daß die Stromquelle (6f⁺, 6f⁻) einen Kondensator (66⁺, 66⁻), der parallel zu der seriellen Schaltung (61⁺, 64⁺ ; 61⁻, 64⁻) geschaltet ist, aufweist.

## Claims

1. Binary-to-bipolar converter comprising first and second means (2b⁺, 2b⁻ ; 2c⁺, 2c⁻ ; 2d⁺, 2d⁻ ; 2e⁺, 2e⁻ ; 2f⁺, 2f⁻) for converting a first logic state ("1") of first and second binary signals (BIN⁺, BIN⁻) into first and second current bipolar pulses (z⁺, z⁻) corresponding to low output impedance states of the first and second converting means respectively, said first logic state only being present in one of said binary signals at any one time, and each of said converting means being at a high impedance state (Z) in response to a second logic state ("0") of the respective binary signal, and means (3b ; 3c ; 3d ; 3e ; 3f) for transforming the first and second pulses (z⁺, z⁻) into opposite polarity pulses of a bipolar signal (BIP) transmitted in a transmission line ($L_1L_2$), characterized in that it comprises means (4b⁺, 4b⁻ ; 5c ; 5d ; 5e ; 5f) for delaying the drop from the low impedance state to the high impedance state (Z) of the first and second converting means whereby the low output impedance state of the first and second converting means is transitory maintained, and abrupt rear edges of said first and second pulses (z⁺, z⁻) are produced after transitions from the first state ("1") to the second state ("0") of the first and second binary (BIN⁺, BIN⁻) signals, respectively.

2. Converter (1b) according to claim 1, wherein first and second converting means comprise first and second transfer gates (2b⁺, 2b⁻), and the delaying means (4b⁺, 4b⁻) delay the pulse rear edges of the first and second binary signals (BIN⁺, BIN⁻) applied to inputs (E⁺, E⁻) of the first and second transfer gates (2b⁺, 2b⁻) respectively thereby applying delayed binary signals to control terminals (C⁺, C⁻) of the transfer gates (2b⁺, 2b⁻).

3. Converter according to claim 2, characterized in that the delaying means relating to the respective one of the first and second binary signals (BIN⁺, BIN⁻) comprise an integrator circuit (4b⁺, 4b⁻) having a resistor (41⁺, 41⁻) and a capacitor (42⁺, 42⁻), said resistor being connected between the input (E⁺, E⁻) and the control terminal (C⁺, C⁻) of the respective transfer gate (2b⁺, 2b⁻).

4. Converter according to claim 3, characterized in that the integrator circuit (4b+, 4b−) comprises a diode (43+, 43−) connected in parallel with the resistor (41+, 41−).

5. Converter according to claim 2, characterized in that the delaying means relating to the respective one of the first and second binary signals (BIN+, BIN−) comprise a bistable flip-flop (44+, 44−) having an input (D) connected to the input (E+, E−) of the respective transfer gate (2b+, 2b−), a clock input (Q) receiving a high-frequency clock signal, and an output (Q) connected to the control terminal (C+, C−) of said respective transfer gate, preferably through an input and an output of an AND gate having another input connected to the input (E+, E−) of the respective transfer gate.

6. Converter (1f) according to claim 1, characterized in that the delaying means comprise means (58, 5f) for applying calibrated pulses (i+) on the output of the converting means (2f+, 2f−) in response to transitions from the first state ("1") to the second state ("0") of the binary signals (BIN+, BIN−), thereby delaying transitions from the low impedance state to the high impedance state (Z) to the first and second converting means (2f+, 2f−).

7. Converter (1f) according to claim 1 or 6, characterized in that it comprises means (63+, 66+ ; 63−, 66−) on the output of the converting means (2f+, 2f−) for calibrating the transitions from the high impedance state (Z) to the low impedance state of the first and second converting means (2f+, 2f−) corresponding to the rise time of the bipolar pulses (z+, z−).

8. Converter (1c) according to claim 1, wherein the first and second converting means comprise first and second transfer gates (2c+, 2c−) having inputs (E+, E−) raised to a predetermined voltage (+V) and control terminals (C+, C−) receiving respectively the first and second binary signals (BIN+, BIN−), characterized in that the delaying means (5c) comprise means (51, 52, 53) for detecting rear transitions from the first logic state ("1") to the second logic state ("0") of the first and second binary signals (BIN+, BIN−), and means (54) connected to outputs (S+, S−) of the transfer gates (2c+, 2c−) for suppressing a transient trailing of means edges in the first and second pulses (z+, z−) in response to the detected transitions (i+).

9. Converted according to claim 8, characterized in that the detecting means comprise a NOR gate (51) receiving the first and second binary signals (BIN+, BIN−), and a differentiating circuit (52, 53) connected to an output of the NOR gate.

10. Converter according to claim 8 or 9, characterized in that the transient trailing suppressing means comprise a transistor (54) having a control electrode connected to an output (55) of the detecting means (51, 52, 53), and two other electrodes connected respectively to outputs (S+, S−) of the transfer gates (2c+, 2c−) transmitting the first and second pulses.

11. Converter according to claim 8 or 9, characterized in that transient trailing suppressing means comprise third and fourth transfer gates (54+, 54−) having inputs (E+, E−) connected to a reference potential terminal (0 volt), control inputs (C+, C−) connected to an output (55) of the detecting means (51, 52, 53), and outputs (S+, S−) connected respectively to outputs (S+, S−) of the first and second transfer gates (2c+, 2c−).

12. Converter (1b) according to any one of claims 1, 6 and 7, characterized in that it comprises means (5T+, 5T−, 22+, 22−) on the output of the converting means for protecting means connected to the input of the converting means against all power supply coming from the transmission line (L₁L₂).

13. Converter (1f) according to claim 1, characterized in that the first and second converting means (2f+, 2f−) comprise each a buffer gate (21+, 21−) preferably series-connected to a diode (22+, 22−), an input of the buffer gate receiving the respective binary signal (BIN+, BIN−) and a cathode of the diode supplying the respective current pulses (z+, z−), and in that the delaying means (5f) comprise means (51, 52, 53) for detecting rear transitions from the first logic state ("1") to the second logic state ("0") of the first and second binary signals (BIN+, BIN−), and means (5T+, 5T−, 56, 57) connected to the cathodes of said diodes (22+, 22−) for suppressing a transient trailing of rear edges in the first and second pulses (z+, z−), in response to the detected transitions (i+).

14. Converter according to claim 13, characterized in that the detecting means comprise a NOR gate (51) receiving the first and second binary signals (BIN+, BIN−) and a differentiating circuit (52, 53) connected to an output of the NOR gate.

15. Converter according to claim 13 or 14, characterized in that transient trailing suppressing means comprise two transistors (5T+, 5T−) having control electrodes connected to an output (55) of the detecting means (51, 52, 53), through a buffer gate (56) connected in series with a resistor (57), second electrodes connected to a reference potential terminal (0 volt), and third electrodes connected to the cathodes of said diodes (22+, 22−) through resistors (58+, 58−) respectively.

16. Converter according to any one of claims 1 to 15, characterized in that the transforming means (3b; 3c) comprise a transformer comprising two primary half-windings (31+, 31−) having a common terminal (33) connected to a reference potential terminal (0 volt), and having two other terminals connected to outputs (C+, C−) of the first and second converting means (2b+, 2b− ; 2c+, 2c−) and transmitting the first and second current pulses (z+, z−) respectively.

17. Converter according to any one of claims 1 to 15, characterized in that the transforming means comprise a transformer (3d) comprising two primary half-windings (31+, 31−) having terminals connected to outputs (S+, S−) of the first and second converting means (2d⁺, 2d⁻), respectively, and a current source (6d) interconnected between a terminal (33) common to the half-windings (31⁺, 31⁻) and to a reference potential terminal (0 volt).

18. Converter according to any one of claims 1 to 15, characterized in that the transforming means comprises a transformer (3e, 3f) including a primary winding (31) having terminals respectively connected to outputs (S⁺, S⁻) of the first and second converting means (2e⁺, 2e⁻ ; 2f⁺, 2f⁻), and first and second current sources (6e⁺, 6e⁻ ; 6f⁺, 6f⁻) having control terminals (63⁺, 63⁻ ; 65⁺, 65⁻) receiving respectively the second and first binary signals (BIN⁺, BIN⁻), and output terminals (collectors of 60⁺, 60⁻) connected respectively to the outputs (S⁺, S⁻) of the first and second converting means (2e⁺, 2e⁻ ; 2f⁺, 2f⁻).

19 Converter according to claim 18, characterized in that each of the current sources (6f⁺, 6f⁻) comprises a buffer gate (65⁺, 65⁻) on the control input.

20. Converter according to any one of claims 17 to 19, characterized in that a current source (6d ; 6e⁺, 6e⁻ ; 6f⁺, 6f⁻) comprises at least one transistor (60 ; 60⁺, 60⁻) and a series combination including a resistor (61 ; 61⁺, 61⁻) and a diode (64 ; 64⁺ , 64⁻) connected between a control electrode of the transistor and a reference potential terminal (0 volt).

21. Converter according to claim 20, characterized in that the diode (64 ; 64⁺, 64⁻) is replaced by a thermistor.

22. Converter according to claim 20 or 21, characterized in that the current source (6f⁺, 6f⁻) comprises a capacitor (66⁺, 66⁻) connected in parallel with said series combination (61⁺, 64⁺ ; 61⁻, 64⁻).

# FIG.1

# FIG.2
## (ART ANTERIEUR)

# FIG.2A
## (ART ANTERIEUR)

FIG.3

FIG.3A

FIG.4

FIG.4A

FIG.5

FIG.5A

## FIG.6

## FIG.6A

## FIG.7

# FIG.8

# FIG.9

# FIG.10

EP 0 277 855 B1